(19) Europäisches Patentamt
European Patent Office
Office européen des brevets

(11) **EP 0 555 946 B1**

(12) **EUROPÄISCHE PATENTSCHRIFT**

(45) Veröffentlichungstag und Bekanntmachung des Hinweises auf die Patenterteilung:
**09.12.1998 Patentblatt 1998/50**

(51) Int. Cl.$^6$: **B60M 3/00**, H02H 11/00, G01R 31/02

(21) Anmeldenummer: 93250041.6

(22) Anmeldetag: **03.02.1993**

(54) **Streckenprüfeinrichtung für Bahnstromanlagen, insbesondere Vollbahnanlagen**

Line testing device for traction current systems, especially standard gauge railway systems

Dispositif de test de ligne pour réseaux de traction, notamment de chemins de fer à voie normale

(84) Benannte Vertragsstaaten:
**AT BE DE DK ES FR IT NL SE**

(30) Priorität: **14.02.1992 DE 4204909**
**14.02.1992 DE 4204911**

(43) Veröffentlichungstag der Anmeldung:
**18.08.1993 Patentblatt 1993/33**

(73) Patentinhaber:
**Elpro BahnstromAnlagen GmbH**
**13053 Berlin (DE)**

(72) Erfinder:
**Gerlach, Horst, Dr, Ing.**
**O-1092 Berlin (DE)**

(56) Entgegenhaltungen:
**EP-A- 0 013 860**     **WO-A-93/03389**
**DE-C- 964 874**

- **P.SCHMIDT 'Energieversorgung elektrischer Bahnen' 1988 , TRANSPRESS , DE * Seite 18; Abbildung 2.6 * * Seite 40; Abbildung 2.29 ***

## Beschreibung

Die Erfindung betrifft eine Prüfeinrichtung für die Streckenprüfung von Anlagen zur Bahnstromversorgung, insbesondere für Vollbahnanlagen, hinsichtlich ihrer Kurzschlußfreiheit.

Bei allen Bahnanlagen wird ein ausgeschalteter Streckenabgang vor einer Wiederinbetriebnahme auf Kurzschlußfreiheit überprüft. Bei Vollbahnanlagen, insbesondere bei der $16^2/_3$-Hz-Bahnstrom-Versorgung, wird ein ausgeschalteter Streckenabgang bisher dadurch geprüft, daß über einen Prüfwiderstand ein Prüfstrom in die Strecke geleitet wird. Die Spannungswerte über der Prüfstrecke bzw. über dem Fehlerwiderstand und dem Prüfwiderstand werden zur Beurteilung des Zustandes der betroffenen Strecke ausgewertet. Je nach dem Ergebnis dieser Auswertung wird die Strecke zugeschaltet oder, z.B. nach einer vorausgegangenen Fehlerauslösung, ganz außer Betrieb gesetzt. Nach einer vorgegebenen Prüfzeit von einigen wenigen Sekunden wird der Prüfstrom mittels eines Schaltgerätes wieder abgeschaltet. Das vorbeschriebene Verfahren ist z.B. aus Schmidt, Energieversorgung elektrischer Bahnen, transpress 1988, S. 18 oder S. 40 zu entnehmen.

Nachteilig ist hierbei die große Verlustleistung bei einem Prüfvorgang von möglicherweise 75 bis 225 kW, setzt man eine Betriebsspannung von 15 kV bei einem Widerstand der Prüfstrecke von z.B. 1 bis 3 kOhm voraus. Dies führt natürlich zu starken Erwärmungen in der Prüfzelle. Unter Umständen können die Stahlblechwände der Prüfzelle dabei so warm werden, daß Nachteile für die Begehbarkeit der Anlage hingenommen werden müssen.

Auch das Schalten der Prüfströme ist aufwendig, weil entweder der Strecken-Leistungsschalter benutzt wird oder ein hierfür extra installierter Lasttrennschalter vorhanden sein muß.

Aufgabe der Erfindung ist es, für eine Streckenprüfeinrichtung für Bahnstromanlagen, insbesondere für Vollbahnanlagen, eine Lösung anzugeben, bei der die Verlustleistung mit ihren damit bedingten Nachteilen vermindert und der Aufwand für die Mittelspannungsschalthandlungen verringert werden.

Erfindungsgemäß wird die Aufgabe dadurch gelöst, daß die Prüfimpedanz, die während der Streckenprüfung über einen Schalter mit einer Stromversorgungseinrichtung, vorzugsweise der Hauptsammelschiene und der zu prüfenden Strecke, vorzugsweise über eine Prüfsammelschiene verbunden ist, aus einem Transformator besteht, dessen Primärwicklung zwischen der Stromversorgungseinrichtung und dem zu prüfenden Streckenabzweig angeordnet ist und dessen Sekundärkreis während der Streckenprüfung über ein Strommeßglied, über einen Schalter und über eine Impedanz geschlossen ist.

Die im Sekundärkreis des Transformators eingeschaltete Impedanz ist vorzugsweise ein Niederspannungskondensator, der die resultierende Impedanz in der Prüfeinrichtung kapazitiv gestaltet und somit keine Reihenresonanz mit der Kapazität, eines beispielsweise langen Einspeisekabels, der Strecke möglich ist.

Als Stromversorgungseinrichtung kann dabei eine Hauptsammelschiene dienen. Die Primärwicklung des Transformators kann mit der zu prüfenden Strecke über eine Prüf-Sammelschiene verbunden sein.

Die bevorzugten Ausgestaltungen für den im Sekundärkreis angeordneten Schalter können den Unteransprüchen entnommen werden.

Bei einer weiteren bevorzugten Ausgestaltung des Transformators besteht die Sekundärwicklung aus zwei Teilwicklungen, die parallelgeschaltet werden können. In einer ersten Prüfstufe wird der Sekundärkreis über nur eine der beiden Teilwicklungen und bevorzugt über eine Impedanz geschlossen. Erweist sich die Strecke dabei als kurzschlußfrei, wird die zweite Teilwicklung parallelgeschaltet und eine endgültige Prüfung vorgenommen. Im Falle eines Kurzschlusses kann so der Prüfstrom noch weiter verringert werden.

Erfindungsgemäß kann die Aufgabe auch dadurch gelöst werden, daß die Prüfimpedanz, die während der Streckenprüfung über einen Schalter mit einer Stromversorgungseinrichtung, vorzugsweise der Hauptsammelschiene und der zu prüfenden Strecke, vorzugsweise über eine Prüfsammelschiene verbunden ist, aus einer Drosselspule besteht. In diesem Fall verfügt die Streckenprüfeinrichtung über eine Meßstelle zur Prüfstromerfassung in dem zu prüfenden Streckenabzweig und/oder eine erste Spannungsmeßstelle zum Erfassen einer Fehlerspannung zwischen dem mit der zu prüfenden Strecke verbundenen Anschluß der Prüfimpedanz und Erdpotential und ggf. eine zweite Spannungsmeßstelle zur erfassung der Spannung über der Prüfimpedanz.

Die Drosselspule kann als Luft- oder als eisengeschlossene Spule ausgeführt sein. In der Form als eisengeschlossene Spule wird sie in bevorzugter Weise mit einem Luftspalt versehen. In einer weiteren bevorzugten Form besteht sie aus zwei Wicklungsteilen, die beim Prüfen gegeneinander geschaltet sind. Die Verbindung der Wicklungsteile läßt sich mit einem Prüfschalter öffnen, der dann über das eine Wicklungsteil und ggf. einen ohmschen Widerstand einen nur noch geringen Prüfreststrom realisiert.

Erfindungsgemäß kann die Aufgabe auch dadurch gelöst werden, daß die Prüfimpedanz, die während der Streckenprüfung über einen Schalter mit einer Stromversorgungseinrichtung, vorzugsweise der Hauptsammelschiene und der zu prüfenden Strecke, vorzugsweise über eine Prüfsammelschiene verbunden ist, aus einem Kondensator besteht. In diesem Fall verfügt die Streckenprüfeinrichtung über eine Meßstelle zur Prüfstromerfassung in dem zu prüfenden Streckenabzweig und/oder eine erste Spannungsmeßstelle zum Erfassen einer Fehlerspannung zwischen dem mit der zu prüfenden Strecke verbundenen Anschluß der Prüfimpedanz und Erdpotential.

Bevorzugt wird die Prüfung einer Strecke durch Einlegen eines Trenners zwischen Prüfsammelschiene und zu prüfender Strecke eingeleitet. Die Prüfung wird nur solange aufrechterhalten, bis die Meßinformationen sicher eingeholt sind bzw. der Prüfstrom einen eingestellten Schwellwert erreicht und hierdurch eine Sofortabschaltung des Prüfstromes vorgenommen wird.

Bei Verwendung eines Transformators als Prüfimpedanz in der Prüfeinrichtung wird zur Einleitung der Streckenprüfung zusätzlich der Schalter auf der Sekundärseite des Transformators eingeschaltet. Überschreitet der Strom im Sekundärkreis einen eingestellten Schwellwert, kann ebenfalls eine Sofortabschaltung des Prüfstromes vorgenommen werden.

Bei einer weiteren bevorzugten Ausführung mit einer Kurzschlußverbindung der Sekundärseite des Transformators wird ein Schaltgerät auf der Mittelspannungsseite, z. B. ein Lasttrennschalter, die Ein- und Ausschaltung der Prüfströme vornehmen.

Weitere bevorzugte Erfindungsmerkmale können den Unteransprüchen entnommen werden.

Die Erfindung soll nachstehend an einem Ausführungsbeispiel näher erläutert werden. In den zugehörigen Zeichnungen zeigen:

Fig.1: die Prüfeinrichtung mit den möglichen Meßstellen,

Fig.2: eine spezielle Form der Drosselspule als Prüfimpedanz

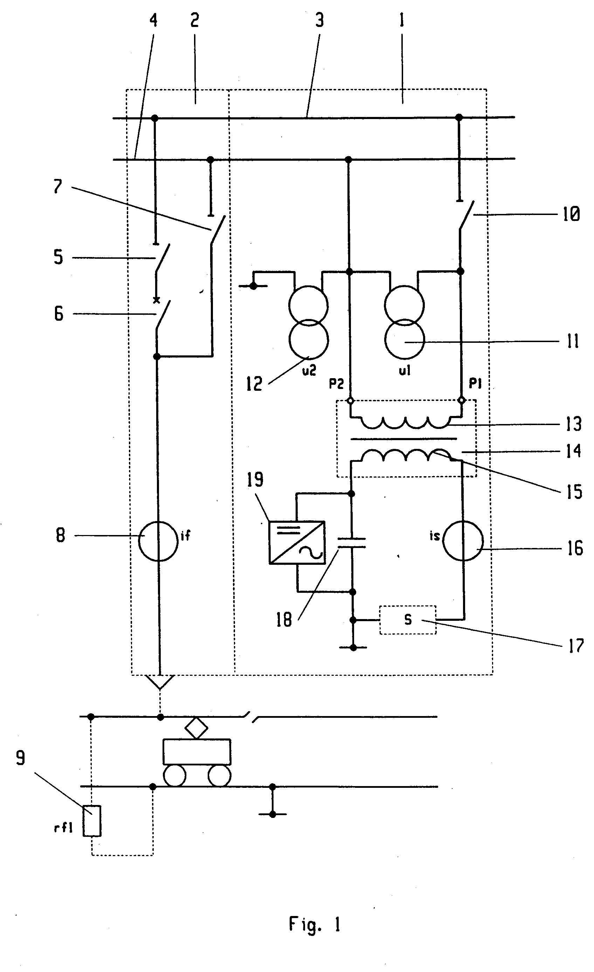

Fig. 1 zeigt die wesentlichen Teile einer $16^2/_3$-Hz-Bahnstromversorgung, als da sind die Streckenprüfeinrichtung 1 und ein Streckenabgang 2, die Hauptsammelschiene 3 und die Prüfsammelschiene 4. Als Prüfimpedanz ist ein Transformator 14 in den Prüfkreis geschaltet. Die Primärwicklung 13 des Transformators 14 ist über eine Anschlußklemme P1 und einen Trenner 10 an die Hauptsammelschiene 3 und mit dem zweiten Wicklungsanschluß über eine Anschlußklemme P2 direkt an die Prüfsammelschiene 4 angeschlossen. Die Sekundärwicklung 15 des Transformators 14 ist mit einem Schalter 17 in Reihe mit einer Strommeßstelle 16 und einem Kondensator 18 abgeschlossen. Der Prüfkreis wird vervollständigt durch den Trenner 7, die Strommeßstelle 8 und die Strecke mit dem Fehlerwiderstand 9 (rf1). Je nach der Auswertelogik können noch zwei Spannungsmeßstellen 11 und 12, nämlich für die primäre Transformatorspannung/Spulenspannung u1 und für die Fehlerspannung u2, vorgesehen sein.

Für den Sonderfall, daß der Schalter 17 nur eine Kurzschlußbrücke ist, wird der Prüfstrom if mittels des Schalters 7 geschaltet, der in diesem Falle ein Lasttrennschalter ist. Diese Variante bietet sich z.B. dann an, wenn eine bereits im Betrieb befindliche Bahnstromanlage, die schon mit einem derartigen Lasttrennschalter 7 ausgerüstet ist, mit einer erfindungsgemäßen Prüfeinrichtung nachgerüstet wird.

Für den allgemeinen Fall, daß der Schalter 17 nach einer der folgenden bevorzugten Ausführungen gebaut ist, ist eine mehr oder minder schnelle Ein- und Ausschaltung des Prüfstromes if durch den Schalter 17 möglich:

- Der Schalter kann als Ausführung mit zwei antiparallelen Thyristoren ausgebildet sein,
- der Schalter kann mit einem GTO-Ventil in der Diagonalen eines Diodenvierecks ausgeführt sein
- der Schalter in der Diagonalen des Diodenvierecks kann auch ein Thyristor mit dazu parallel angeordnetem Löschzweig sein
- der Schalter ist ein Niederspannungsschütz
- der Schalter ist ein Leistungsschalter.

Wegen der kürzeren Schaltzeit und der damit deutlich zu verringernden Prüfzeit empfiehlt sich natürlich ein elektronischer Schalter auf der Sekundärseite des Transformators 14 mit einer passend gewählten niedrigen Nennspannung.

Vor dem Schalten des Schalters 17 kommt über den leerlaufenden Transformator 14 kein nennenswerter Strom zustande. Der leerlaufende Transformator 14 kann deshalb mit einem Trennschalter 10 ein- und ausgeschaltet werden.

Zur Gewährleistung einer optimalen Anpassung der resultierenden Impedanz der Prüfeinrichtung an die zu prüfende Strecke besteht der Kondensator 18 aus Teilkondensatoren, die über entsprechende Schaltglieder, z.B. Schütze, Thyristoren in Antiparallelschaltung, zum Erreichen der jeweils erforderlichen Kapazität in Reihe und/oder parallel geschaltet werden. Vorteilhafterweise werden die Schaltglieder von einer speicherprogrammierbaren Steuerung gesteuert, die für die jeweils zu prüfende Strecke vorprogrammiert ist.

Bei der zweiten Lösungsvariante wird über die Anschlußklemmen P1 und P2 eine Drosselspule 20 als Prüfimpedanz in den Prüfkreis geschaltet.

Beim Auslösen und Abschalten des Leistungsschalters 6 wird der Prüfstrom if in den Prüfkreis durch das Einschalten des Schalters 7, der in diesem Falle ein Lasttrennschalter ist, eingeleitet.

Entsprechend einer weiteren Lösungsvariante kann über die Anschlußklemmen P1 und P2 ein Kondensator als Prüfimpedanz in die Prüfeinrichtung geschaltet werden.

In einer ersten bevorzugten Variante der Prüfauswertung kann der Strom is in der Strommeßstelle 16 erfaßt werden. Falls eine Schnellauslösung infolge Überschreitung eines eingestellten Schwellwertes für den Strom is erfolgt, ist die Prüfung negativ. Es erfolgt keine Einschaltung der Strecke. Falls kein Ansprechen erfolgt, wird nach einer eingestellten Prüfzeit, z. B. drei Sekunden, der Prüfstrom if mittels des Schalters 17 abgeschaltet. Anschließend kann die soeben geprüfte Strecke, nach Abschaltung der Prüfeinrichtung durch den Trenner 7, zugeschaltet werden.

Diese Art der Auswertung ergibt die billigste Lösung, da zur Messung nur ein einzelner Niederspannungs-Stromwandler benötigt wird.

In einer zweiten bevorzugten Variante erfolgt die Auswertung der geprüften Strecke durch die Erfassung der Spannung über dem Niederspannungskondensator 18. Mit kleiner werdendem Fehlerwiderstand steigt die Spannung am Niederspannungskondensator an, so daß bei einem Wert $uc > uc_{grenz}$ die Strecke negativ geprüft ist.

In einer weiteren Variante der Prüfauswertung kann der Quotient $ü * u2/is$ (Übertragungsfaktor mal Fehlerspannung, geteilt durch den Strom im Sekundärkreis des Transformators) ausgewertet werden, welcher der Fehlerimpedanz $zf1$ entspricht, wobei der Übertragungsfaktor das Windungszahlverhältnis von Primärwicklung 13 zur Sekundärwicklung 15 bedeutet. Die Fehlerimpedanz $zf1$ entspricht im wesentlichen dem Fehlerwiderstand $rf1$.

In einer vierten bevorzugten Variante kann auch die Fehlerspannung $u2$ allein ausgewertet werden, wie es auch bei der Prüfmethode des o.a. Standes der Technik gehandhabt wird. Diese Variante eignet sich deshalb ebenfalls bevorzugt für nachzurüstende Anlagen.

In einer weiteren Variante wird der Quotient $u2/u1$ (Fehlerspannung zu Primär-/Spulenspannung) herangezogen. Durch den Bezug auf die Primär-/Spulenspannung wird die Messung von der Höhe der Netzspannung unabhängig, was auch für die dritte und die folgende Variante gilt, nach der der Quotient $u2/if$ (Fehlerspannung zu Prüfstrom), d.h. ebenfalls Bestimmung der Fehlerimpedanz, als Maß für den Zustand der Strecke ausgewertet wird.

Auch kann in einer siebenten Variante der Prüfstrom $if$ an der Strommeßstelle 8 ausgewertet werden.

Als weitere netzspannungsunabhängige Auswertemöglichkeit kommt das Verhältnis $u2/uNetz$ (Fehlerspannung zu Netzspannung) in Betracht.

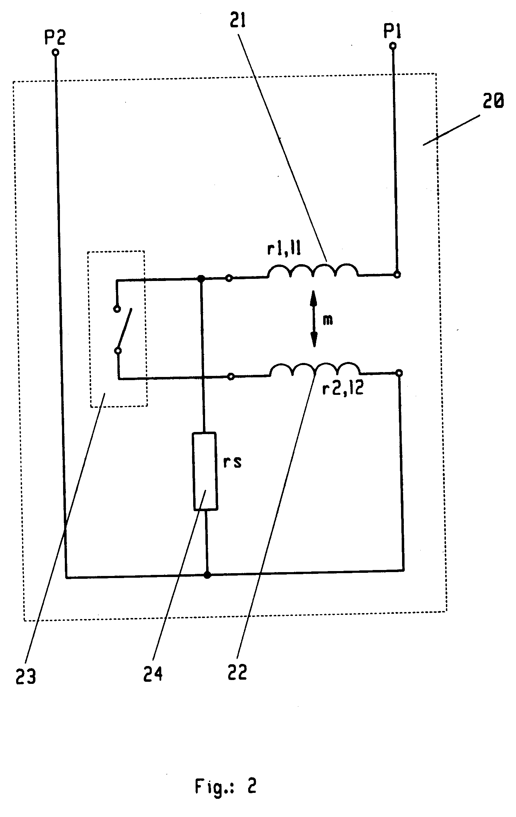

Fig.2 zeigt als Prüfimpedanz eine spezielle Ausführung der Drosselspule 20 mit den beiden Wicklungsteilen 21 und 22, die mittels eines Prüfschalters 23 in Reihe gegeneinander geschaltet werden können.

Beim Schließen des Prüfschalters 23 sind die beiden Wicklungsteile 21 und 22 gegeneinander geschaltet, so daß die Prüfimpedanz

$$zp = r1 + r2 + jw (l1 + l2 - 2m)$$

ist.

Beim geöffneten Prüfschalter 23 ist die Prüfimpedanz für den Restprüfstrom

$$zr = rs + r1 + jwl1.$$

Hierbei ist $rs$ der Wert eines Widerstands 24, der parallel zu der Reihenschaltung von Prüfschalter 23 und Wicklungsteil 22 liegt und der den Restprüfstrom sowohl in der Höhe als auch in der Phasenlage ($\cos \varphi$)

mitbestimmt. Die Wicklungsteile 21 und 22 werden bestimmt durch ihre ohmschen Widerstände $r1$ und $r2$, ihre Induktivitäten $l1$ und $l2$ sowie die Gegeninduktivität $m$.

Vorteilhaft kann hierbei durch die Gegeneinanderschaltung der Wicklungsteile 21 und 22 bei geschlossenem Prüfschalter 23 mit der Prüfimpedanz $zp$ ein Prüfstrom sowie durch die Reihenschaltung von Wicklungsteil 21 und Widerstand 24 bei geöffnetem Prüfschalter 23 mit der Prüfimpedanz $zr$ ein kleiner Reststrom erreicht werden. Insbesondere ist es vorteilhaft, wenn dazu auch noch durch kleine Wicklungswiderstände $r1$, $r2$ der Wicklungsteile 21 und 22 der Drosselspule 20 die Wicklungserwärmung klein gehalten werden kann und somit oftmalige Prüfstöße möglich sind.

Alle Schalt- und Meßvarianten haben gegenüber bisherigen Prüfungen den Vorteil, daß die Verluste in der Prüfimpedanz, also im Transformator, bzw. in der Drosselspule, bzw. in dem Kondensator wesentlich kleiner als in einem Prüfwiderstand sind, da nur noch ein Teil der in der Prüfeinrichtung vorhandenen Impedanz ohmisch ist. Außerdem kann im Kurzschlußfall der Prüfvorgang abgebrochen werden, wenn der Strom einen voreingestellten Schwellwert erreicht. Auf diese Weise kann nicht nur die Verlustleistung, sondern insgesamt die Verlustenergie radikal verringert werden, die somit nur noch einen Bruchteil der Verlustenergie gegenüber der bisher bekannten Lösung betragt. Es können beliebig oft und schnell Prüfungen eines Streckenabgangs wiederholt werden und die Prüfung eines anderen Streckenabgangs sofort angeschlossen werden.

Infolge der schnellen und einfachen Schaltung auf der Sekundärseite des Transformators kann auch die Prüfzeit sehr klein gehalten werden. So ist es nicht unbedingt nötig, eine Prüfzeit von mehreren Sekunden einzuhalten. Bei Anwendung der ersten bevorzugten Auswertevariante, nämlich Abschalten des Schalters 17 bei Erreichen des eingestellten Schwellwertes an der Strommeßstelle 16, kann eine extrem kleine Verlustenergie erreicht werden.

**Patentansprüche**

1. Streckenprüfeinrichtung für Bahnstromanlagen, insbesondere für Vollbahnanlagen, die eine Prüfimpedanz aufweist, die über einen Schalter (10) mit einer Stromversorgungseinrichtung, vorzugsweise der Hauptsammelschiene (3), und der zu prüfenden Strecke, vorzugsweise über eine Prüfsammelschiene (4) und einen Trennschalter (7), verbunden ist, **dadurch gekennzeichnet**, daß die Prüfimpedanz aus einem Transformator (14) besteht, dessen Primärwicklung (13) einerseits mit der Hauptsammelschiene (3) und andererseits mit der zu prüfenden Strecke verbunden ist und dessen Sekundärwicklung (15) während der Streckenprüfung über einen Schalter (17), über ein Strommeßglied (16) und über eine Impedanz (18) kurzgeschlossen ist.

2. Streckenprüfeinrichtung für Bahnstromanlagen, insbesondere für Vollbahnanlagen, die eine Prüfimpedanz aufweist, die über einen Schalter (10) mit einer Stromsversorgungseinrichtung, vorzugsweise der Hauptsammelschiene (3), und der zu prüfenden Strecke, vorzugsweise über eine Prüfsammelschiene (4), verbunden ist, und über eine Meßstelle (8) zur Prüfstromerfassung in dem zu prüfenden Streckenabzweig und/oder eine erste Spannungsmeßstelle (12) zur Erfassung einer Fehlerspannung (u2) zwischen dem mit der zu prüfenden Strecke verbundenen Anschluß der Prüfimpedanz und Erdpotential und ggf. eine zweite Spannungsmeßstelle (11) zur Erfassung der Spannung (u1) über der Prüfimpedanz verfügt, **dadurch gekennzeichnet**, daß die Prüfimpedanz aus einer Drosselspule (20) besteht.

3. Streckenprüfeinrichtung für Bahnstromanlagen, insbesondere für Vollbahnanlagen, die eine Prüfimpedanz aufweist, die über einen Schalter (10) mit einer Stromsversorgungseinrichtung, vorzugsweise der Hauptsammelschiene (3), und der zu prüfenden Strecke, vorzugsweise über eine Prüfsammelschiene (4), verbunden ist, und über eine Meßstelle (8) zur Prüfstromerfassung in dem zu prüfenden Streckenabzweig und/oder eine erste Spannungsmeßstelle (12) zur Erfassung einer Fehlerspannung (u2) zwischen dem mit der zu prüfenden Strecke verbundenen Anschluß der Prüfimpedanz und Erdpotential verfügt, **dadurch gekennzeichnet, daß** die Prüfimpedanz aus einem Kondensator besteht.

4. Streckenprüfeinrichtung nach Anspruch 1, **dadurch gekennzeichnet**, daß die im Sekundärkreis des Transformators (14) angeordnete Impedanz ein Niederspannungskondensator (18) ist, der vorteilhafterweise in Teilkondensatoren unterteilt ist und diese zur optimalen Anpassung, vorzugsweise durch eine Vorprogrammierung, an die zu prüfende Strecke durch Schaltglieder parallel und/oder in Reihe zueinander geschaltet werden.

5. Streckenprüfeinrichtung nach Anspruch 1, **dadurch gekennzeichnet**, daß die im Sekundärkreis des Transformators angeordnete Impedanz (18) ein ohmscher Widerstand ist, der, z.B. bei einer zweistufigen Prüfung, zur Nachprüfung der Strecke durch einen Schalter, z.B. ein Niederspannungsschütz, überbrückt ist.

6. Streckenprüfeinrichtung nach Anspruch 1, **dadurch gekennzeichnet**, daß als Schalter (17) im Sekundärkreis des Transformators (14) zwei antiparallel geschaltete Thyristoren angeordnet sind.

7. Streckenprüfeinrichtung nach Anspruch 1, **dadurch gekennzeichnet**, daß als Schalter (17) im Sekundärkreis des Transformators (14) ein Niederspannungs-Schütz angeordnet ist.

8. Streckenprüfeinrichtung nach Anspruch 1, **dadurch gekennzeichnet**, daß als Schalter (17) im Sekundärkreis des Transformators (14) ein elektronischer Schalter, z.B. ein GTO-Thyristor angeordnet ist.

9. Streckenprüfeinrichtung nach Anspruch 1 , **dadurch gekennzeichnet**, daß die Sekundärwicklung (15) des Transformators (14) für eine zweistufige Prüfung in zwei parallelschaltbare Teile aufgeteilt ist.

10. Streckenprüfeinrichtung nach Anspruch 1, **dadurch gekennzeichnet**, daß der Sekundärkreis des Transformators (14) über eine fest eingelegte Kurzschlußbrücke geschlossen ist.

11. Streckenprüfeinrichtung nach Anspruch 2, **dadurch gekennzeichnet**, daß die Drosselspule (20) aus zwei Wicklungsteilen (21,22) aufgebaut ist, die vorzugsweise durch einen Prüfschalter (23) gegeneinander in Reihe schaltbar sind und vorzugsweise parallel zur Reihenschaltung von Prüfschalter (23) und zweitem Wicklungsteil (22) der Drosselspule (20) ein Widerstand (24) angeordnet ist.

12. Streckenprüfeinrichtung nach Anspruch 1, **dadurch gekennzeichnet**, daß als Maß für die Beurteilung des Streckenzustandes ein Strom ($i_s$) an dem Strommeßglied (16) im Sekundärkreis des Transformators (14) erfaßt wird.

13. Streckenprüfeinrichtung nach Anspruch 1 und 4, **dadurch gekennzeichnet**, daß als Maß für die Beurteilung des Streckenzustandes die Spannung des Niederspannungskondensators (18) an einer Meßstelle (19) im Sekundärkreis des Transformators (14) erfaßt wird.

14. Streckenprüfeinrichtung nach Anspruch 1 bis 3, **dadurch gekennzeichnet**, daß als Maß für die Beurteilung des Streckenzustandes zwischen der mit der zu prüfenden Strecke verbundenen Anschlußklemme (P2) der Prüfimpedanz und Erdpotential an einer bzw. der ersten Spannungsmeßstelle (12) die Fehlerspannung (u2) erfaßt wird.

15. Streckenprüfeinrichtung nach Anspruch 14 in Verbindung mit Anspruch 1 oder 2, **dadurch gekennzeichnet**, daß als Maß für die Beurteilung des Streckenzustandes außerdem parallel zu den Anschlußklemmen (P1, P2) der Prüfimpedanz an einer bzw. der zweiten Spannungsmeßstelle (11) die Primär- /Spulenspannung (u1) des Transformators (14) bzw. der Drosselspule (20) erfaßt wird.

16. Streckenprüfeinrichtung nach Anspruch 1 bis 3, **dadurch gekennzeichnet**, daß als Maß für die Beurteilung des Streckenzustandes der Prüfstrom (if) im zu prüfenden Streckenabzweig an einer bzw. der Meßstelle (8) zur Prüfstromerfassung erfaßt wird.

**Claims**

1. Line test device for railway electricity equipment, particularly for complete railway equipment. This is connected through a switch (10) to a power supply, preferably the main bus bar (3) and the line to be tested, preferably through a test bus bar (4) and an isolating switch (7) and is equipped with devices to measure current and/or voltage. **This is characterised in that** the test impedance consists of a transformer (14) whose primary winding (13) is connected at one side to the main bus bar (3) and at the other side to the line to be tested and whose secondary winding (15) is short-circuited through a switch (17), a current measuring circuit (16) and an impedance (18) during the measurement of the line.

2. Line test device for railway electricity equipment, particularly for complete railway equipment. This is connected through a switch (10) to a power supply, preferably the main bus bar (3) and the line to be tested, preferably through a test bus bar (4) and through a measuring point (8) to measure the test current in the line branch to be tested and/or a first voltage measuring point (12) to measure an error voltage (u2) between the terminal of the test impedance connected to the line to be tested and ground potential, and possibly a second voltage measuring point (11) to measure the voltage (u1) across the test impedance. **This is characterised in that** the test impedance consists of a choke coil (20).

3. Line test device for railway electricity equipment, particularly for complete railway equipment. This is connected through a switch (10) to a power supply, preferably the main bus bar (3) and the line to be tested, preferably through a test bus bar (4) and through a measuring point (8) to measure the test current in the line branch to be tested and/or a first voltage measuring point (12) to measure an error voltage (u2) between the terminal of the test impedance connected to the line to be tested and ground potential. **This is characterised in that** the test impedance consists of a capacitor.

4. Line test device according to claim 1, **characterised in that** the impedance located in the secondary circuit of the transformer (14) is a low-voltage capacitor (18) which is most appropriately divided into several capacitors. For optimum adjustment, preferably by initial programming, these are connected through switching elements to the line to be tested and are in parallel and/or series to each other.

5. Line test device according to claim 1, **characterised in that** the impedance located in the secondary circuit of the transformer (18) is an ohmic resistor which may be bridged by a switch, e.g. a low-voltage relay, to test the line in a two-stage test.

6. Line test device according to claim 1, **characterised in that** the switch (17) in the secondary circuit of the transformer (14) consists of two thyristors in an antiparallel circuit.

7. Line test device according to claim 1, **characterised in that** the switch (17) in the secondary circuit of the transformer (14) consists of a low-voltage relay.

8. Line test device according to claim 1, **characterised in that** the switch (17) in the secondary circuit of the transformer (14) consists of an electronic switch, e.g. a GTO thyristor.

9. Line test device according to claim 1, **characterised in that** the secondary winding (15) of the transformer (14) is divided into two sections which can be switched in parallel for a two-stage test.

10. Line test device according to claim 1, **characterised in that** the secondary circuit of the transformer (14) is short-circuited by a fixed bridge.

11. Line test device according to claim 2, **characterised in that** the choke coil (20) consists of two partial windings (21, 22) which can be connected in series, preferably by a test switch (23), and in which a resistor (24) is preferably arranged in parallel to the series circuit of the test switch (23) and the second winding (22) of the throttle coil (20).

12. Line test device according to claim 1, **characterised in that** a current ($i_s$) in the secondary circuit of the transformer (14) is measured by the current measuring circuit (16) to evaluate the state of the line.

13. Line test device according to claims 1 and 4, **characterised in that** the voltage of the low-voltage capacitor (18) at the measuring point (19) in the secondary circuit of the transformer (14) is measured to evaluate the state of the line.

14. Line test device according to claims 1 to 3, **characterised in that** the error voltage (u2) between terminal (P2) of the test impedance connected to the line to be tested and ground potential is measured at one, i.e. the first voltage measuring point (12) to evaluate the state of the line.

15. Line test device according to claim 14 in conjunction with claim 1 or 2, **characterised in that** the primary/coil voltage (u1) of the transformer (14) or the choke coil (20) parallel to the terminals (P1, P2) of the test impedance is measured at one, i.e. the second voltage measuring point (11) to evaluate the state of the line.

16. Line test device according to claims 1 to 3, **characterised in that** the test current (if) in the line branch to be tested is measured at one, i.e. the second measuring point (8) to evaluate the state of the line.

## Revendications

1. Dispositif de contrôle de lignes pour les installations à courant de traction, notamment pour des chemins de fer à voie normale, présentant une impédance de contrôle reliée par un commutateur (10) à un dispositif d'alimentation de courant, de préférence à la barre omnibus principale (3) et à la ligne à contrôler, de préférence via une barre omnibus de contrôle (4) et un sectionneur (7) et disposant d'appareils de saisie du courant et/ou de la tension (8, 11, 12, 16), caractérisé en ce que l'impédance de contrôle est constituée d'un transformateur (14) dont le bobinage primaire (13) est relié d'une part à la barre omnibus principale (3) et d'autre part à la ligne à contrôler et dont le bobinage secondaire (15) est mis en court-circuit durant le contrôle de la ligne via un interrupteur (17), un élément de mesure du courant (16) et une impédance (18).

2. Dispositif de contrôle de lignes pour les installations à courant de traction, notamment pour des chemins de fer à voie normale, présentant une impédance de contrôle reliée par un commutateur (10) à un dispositif d'alimentation de courant, de préférence à la barre omnibus principale (3) et à la ligne à contrôler, de préférence via une barre omnibus de contrôle (4), disposant d'un point de mesure (8) pour la saisie du courant de contrôle dans la dérivation de la ligne à contrôler et/ou d'un premier point de mesure de la tension (12) pour la saisie de la tension de défaut (u2) entre le raccordement de l'impédance de contrôle connectée à la ligne à contrôler et le potentiel terrestre et éventuellement un second point de mesure de la tension (11) pour la saisie de la tension (u1) au-dessus de l'impédance de contrôle, **caractérisé en ce que** l'impédance de contrôle est constituée d'une bobine de self.

3. Dispositif de contrôle de lignes pour les installations à courant de traction, notamment pour des chemins de fer à voie normale, présentant une impédance de contrôle reliée par un commutateur (10) à un dispositif d'alimentation de courant, de préférence à la barre omnibus principale (3) et à la ligne à contrôler, de préférence via une barre omnibus de contrôle (4), disposant d'un point de mesure (8) pour la saisie du courant de contrôle dans la dérivation de la ligne à contrôler et/ou d'un premier point de mesure de la tension (12) pour la saisie de la tension de défaut (u2) entre le raccordement de l'impédance de contrôle connectée à la ligne à contrôler et le potentiel terrestre, caractérisé en ce que l'impédance de contrôle est constituée d'un condensateur.

4. Dispositif de contrôle de lignes selon la revendication 1, **caractérisé en ce que** l'impédance montée dans le circuit secondaire du transformateur (14) est un condensateur basse tension (18), de préférence divisé en condensateurs partiels qui, pour assurer une adaptation optimale, sont connectés à la ligne à contrôler, de préférence par une pré-programmation, via des éléments de commutation montés en parallèle et/ou en série entre eux.

5. Dispositif de contrôle de lignes selon la revendication 1, **caractérisé en ce que** l'impédance (18) montée dans le circuit secondaire du transformateur est une résistance ohmique qui, pour un contrôle à deux niveaux par exemple, est ponté par un commutateur, par exemple un contacteur auxiliaire basse tension, afin d'assurer un second contrôle de la ligne.

6. Dispositif de contrôle de lignes selon la revendication 1, **caractérisé en ce que** deux thyristors antiparallèles sont utilisés comme commutateurs (17) dans le circuit secondaire du transformateur (14).

7. Dispositif de contrôle de lignes selon la revendication 1, **caractérisé en ce qu'**un contacteur auxiliaire basse tension est utilisé comme commutateur (17) dans le circuit secondaire du transformateur (14).

8. Dispositif de contrôle de lignes selon la revendication 1, **caractérisé en ce qu'**un thyristor GTO est par exemple utilisé comme commutateur (17) dans le circuit secondaire du transformateur (14).

9. Dispositif de contrôle de lignes selon la revendication 1, **caractérisé en ce que** le bobinage secondaire (15) du transformateur (14) est divisé en deux éléments commutables en parallèle pour un contrôle à deux niveaux.

10. Dispositif de contrôle de lignes selon la revendication 1, **caractérisé en ce que** le circuit secondaire du transformateur (14) est fermé par un pont de court-circuit fixe.

11. Dispositif de contrôle de lignes selon la revendication 2, **caractérisé en ce que** la bobine de self (20) est constituée de deux éléments de bobinage (21, 22) pouvant être de préférence commutés en série entre eux par un commutateur de contrôle (23) et qu'une résistance (24) est disposée de préférence en parallèle au montage en série du commutateur de contrôle (23) et du second élément de bobinage (22) de la bobine de self (20).

12. Dispositif de contrôle de lignes selon la revendication 1, **caractérisé en ce qu'**un courant ($I_S$) est saisi à l'élément de mesure du courant (16) dans le circuit secondaire du transformateur (14) afin de servir de mesure de l'évaluation de l'état de la ligne.

13. Dispositif de contrôle de lignes selon les revendications 1 et 4, **caractérisé en ce que** la tension du condensateur basse tension (18) est saisie en un point de mesure (19) dans le circuit secondaire du transformateur (14) afin de servir de mesure de l'évaluation de l'état de la ligne.

14. Dispositif de contrôle de lignes selon les revendications 1 à 3, **caractérisé en ce que** la tension de défaut (u2) est saisie entre la borne de connexion (P2) de l'impédance de contrôle raccordée à la ligne à contrôler et le potentiel terrestre, à un ou au premier point de mesure de la tension (12) afin de servir de mesure de l'évaluation de l'état de la ligne.

15. Dispositif de contrôle de lignes selon la revendication 14 en liaison avec la revendication 1 ou 2, **caractérisé en ce que** la tension primaire/de bobine (u1) du transformateur (14) ou de la bobine de self (20) est en outre saisie parallèlement aux bornes de connexion (P1, P2) de l'impédance de contrôle à un ou au premier point de mesure de la tension (11) afin de servir de mesure de l'évaluation de l'état de la ligne.

16. Dispositif de contrôle de lignes selon les revendications 1 à 3, **caractérisé en ce que** le courant de contrôle (if) est saisi dans la dérivation de la ligne à contrôler en un ou au point de mesure (8) de saisie du courant de contrôle afin de servir de mesure de l'évaluation de l'état de la ligne.

Fig. 1

Fig.: 2